# EUROPEAN PATENT APPLICATION

(11) **EP 4 675 652 A1**
(43) Date of publication of application: **07.01.2026**
(21) Application number: 23929941.5
(22) Date of filing: 10.11.2023
(51) Int. Cl.: H01F 27/24, H01F 27/06

(54) **CIRCUIT BOARD INTEGRATED INDUCTOR, INDUCTOR, AND ELECTRONIC DEVICE**

(30) Priority: 30.03.2023 CN 202310331483
(71) Applicant: GUANGDONG OPPO MOBILE TELECOMMUNICATIONS CORP., LTD., Dongguan, Guangdong 523860 (CN); Hangzhou Dianzi University, Hangzhou, Zhejiang 310018 (CN)
(72) Inventor: CHEN, Yijun, Dongguan, Guangdong 523860 (CN); WANG, Ningning, Dongguan, Guangdong 523860 (CN); ZHENG, Kaicheng, Dongguan, Guangdong 523860 (CN)
(74) Representative: Novagraaf Technologies
(86) International application number: PCT/CN2023/130949
(87) International publication number: WO 2024/198371

(57) **Abstract**

A circuit board integrated inductor includes: a circuit board; and an inductor, including a magnetic core and a coil. The magnetic core is embedded in the circuit board, and the coil is at least partially embedded in the circuit board and surrounds an outer periphery of the magnetic core. The magnetic core includes a first magnetic layer and a second magnetic layer insulated from the first magnetic layer; the first magnetic layer includes a plurality of magnetic sub-members, each of the plurality of magnetic sub-members extends along a first direction, and the plurality of magnetic sub-members are spaced apart from each other along a second direction and arranged on a surface of the second magnetic layer, wherein the first direction intersects the second direction.

## Description

### TECHNICAL FIELD

Embodiments of the present disclosure relate to the technical field of electrics, and more specifically, to a circuit board integrated inductor, an inductor, and an electronic device.

### BACKGROUND

In electronic circuits, an inductor may limit current flow of an alternating current. The inductor and a resistor or a capacitor may cooperatively form a high-pass filter, a low-pass filter, a phase-shift circuit, and a resonant circuit. Therefore, the inductor may be widely used in various instruments and equipment. However, the inductor in the art may have a large eddy current loss, such that an efficiency of the inductor may be greatly reduced, causing excessive heating.

### SUMMARY

In a first aspect, the present disclosure provides a circuit board integrated inductor, including:
A circuit board; and
An inductor, including a magnetic core and a coil, where the magnetic core is embedded in the circuit board, and the coil is at least partially embedded in the circuit board and surrounds an outer periphery of the magnetic core.

The magnetic core includes a first magnetic layer and a second magnetic layer insulated from the first magnetic layer; the first magnetic layer includes a plurality of magnetic sub-members, each of the plurality of magnetic sub-members extends along a first direction, and the plurality of magnetic sub-members are spaced apart from each other along a second direction and arranged on a surface of the second magnetic layer, wherein the first direction intersects the second direction.

In a second aspect, the present disclosure provides an inductor, including:

A magnetic core, including a first magnetic layer and a second magnetic layer insulated from the first magnetic layer; where the first magnetic layer includes a plurality of magnetic sub-members, each of the plurality of magnetic sub-members extends along a first direction; the plurality of magnetic sub-members are spaced apart from each other along a second direction and arranged on a surface of the second magnetic layer; the first direction intersects the second direction; and

A coil, winding around an outer periphery of the magnetic core.

In a third aspect, the present disclosure provides an electronic device, including:
A display;
The the circuit board integrated inductor according to the first aspect or the inductor according to the second aspect; and
A processor, electrically connected to the coil in the circuit board integrated inductor or in the inductor and to the display, where the processor is configured to control a magnitude and a direction of a current flowing through the coil.

### BRIEF DESCRIPTION OF THE DRAWINGS

In order to more clearly illustrate technical solutions in embodiments of the present disclosure, accompanying drawings used in the embodiments will be briefly introduced below. Obviously, the accompanying drawings in the following description show only some of the embodiments of the present disclosure, and any ordinary skilled person in the art may obtain other accompanying drawings based on these drawings without creative work.
FIG. 1 is a perspective view of a part of a circuit board integrated inductor according to an embodiment of the present disclosure.
FIG. 2 is a structural schematic view of an inductor according to an embodiment of the present disclosure.
FIG. 3 is a cross-sectional view of the inductor shown in FIG. 2, taken along an A-A direction, according to an embodiment of the present disclosure.
FIG. 4 is a cross-sectional view of the inductor shown in FIG. 2, taken along the A-A direction, according to another embodiment of the present disclosure.
FIG. 5 is a structural schematic view of the inductor according to another embodiment of the present disclosure.
FIG. 6 is an enlarged view of a dashed-line block I shown in FIG. 5 of the present disclosure.
FIG. 7 is a cross-sectional view of the inductor shown in FIG. 2, taken along the A-A direction, according to still another embodiment of the present disclosure.
FIG. 8 is an enlarged view of a dashed-line block II shown in FIG. 7 of the present disclosure.
FIG. 9 is a cross-sectional view of a second magnetic layer according to an embodiment of the present disclosure.
FIG. 10 is a structural schematic view of a coil according to an embodiment of the present disclosure.
FIG. 11 is a structural schematic view of the coil shown in FIG. 10, being viewed from another viewing angle.
FIG. 12 is a structural schematic view of the inductor according to another embodiment of the present disclosure.
FIG. 13 is a structural schematic view of the inductor shown in FIG. 12, being viewed from another viewing angle.
FIG. 14 is a cross-sectional view of a part of the circuit board integrated inductor shown in FIG. 1, taken along a direction B-B, according to an embodiment of the present disclosure.
FIG. 15 is a flow chart of a preparation method for the circuit board integrated inductor according to an embodiment of the present disclosure.
FIG. 16 is a flow chart of a preparation method for a magnetic core according to an embodiment of the present disclosure.
FIG. 17 is a structural schematic view of an electronic device according to an embodiment of the present disclosure.
FIG. 18 is an exploded view of a part of the electronic device according to an embodiment of the present disclosure.
FIG. 19 is a circuit block diagram of the electronic device according to an embodiment of the present disclosure.

Reference numerals in the drawings:
100-circuit board integrated inductor, 10-circuit board, 101-via hole, 11-first surface, 12-first substrate, 13-second surface, 14-support insulating layer, 16-second substrate, 30-inductor, 31-magnetic core, 311-first magnetic layer, 3111-magnetic sub-member, 313-second magnetic layer, 3131-magnetic film sub-layer, 3133-insulating sub-layer, 3135-bonding sub-layer, 33-coil, 331-first wire, 333-second wire, 335-electrical connection member, 300-electronic device, 310-display, 320-middle frame, 330-processor, 340-housing, 341- light-transmitting portion, 350-memory, 370-camera module.

### DETAILED DESCRIPTIONS

In a first aspect, the present disclosure provides a circuit board integrated inductor, including following components.

A circuit board may be arranged.

An inductor may be arranged and include a magnetic core and a coil. The magnetic core may be embedded in the circuit board. The coil may be at least partially embedded in the circuit board and may surround an outer periphery of the magnetic core.

The magnetic core may include a first magnetic layer and a second magnetic layer insulated from the first magnetic layer. The first magnetic layer may include a plurality of magnetic sub-members, each of the plurality of magnetic sub-members may extends along a first direction, and the plurality of magnetic sub-member are spaced apart from each other along a second direction and disposed on a surface of the second magnetic layer. The first direction may intersect the second direction.

In some embodiments, the coil may be a helical structure, winding around an axial direction. Each of the plurality of magnetic sub-members may have magnetic anisotropy and a first hard axis. An angle α between the first hard axis and the axial direction may be within a range of 0° ≤ α ≤ 20°.

In some embodiments, each of the plurality of magnetic sub-members may have magnetic anisotropy and the first hard axis, and an angle β between the first hard axis and the first direction may be within a range of 0° ≤ β ≤ 20°.

In some embodiments, along a second direction, a width w of each of the plurality of magnetic sub-members may be in a range of 100 µm ≤ w ≤ 500 µm, and a spacing d between adjacent two of the plurality of magnetic sub-members may be in a range of 10 µm ≤ d ≤ 50 µm.

In some embodiments, orthographic projections of all of the plurality of magnetic sub-members onto a surface of the second magnetic layer facing the first magnetic layer has an area s1, the surface of the second magnetic layer facing the first magnetic layer has an area s2, and 50% ≤ s1/s2 ≤ 98%.

In some embodiments, the second magnetic layer may include N magnetic film sub-layers and at least N-1 insulating sub-layers. The N magnetic film sub-layers and the N-1 insulating sub-layers may be alternately stacked along a thickness direction of the circuit board, and the N ≥ 2 and may be a positive integer.

In some embodiments, each of the N magnetic film sub-layers may have magnetic anisotropy and a second hard axis. The coil may be a helical structure and wind around an axial direction. An angle γ between the second hard axis and the axial direction may be within a range of 0° ≤ γ ≤ 20°.

In some embodiments, each of the plurality of magnetic sub-members may have magnetic anisotropy and the first hard axis. An angle θ between the first hard axis and the second hard axis may be within a range of 0° ≤ θ ≤ 20°.

In some embodiments, the coil may include a plurality of first wires and a plurality of second wires. The plurality of first wires may be spaced apart from each other along an extension direction of the circuit board and disposed at a same side of the magnetic core. The plurality of second wires may be spaced apart from each other along the extension direction of the circuit board and disposed on a side of the magnetic core opposite to the plurality of first wires. The plurality of first wires and the plurality of second wires are alternately connected in series to each other.

In some embodiments, the circuit board may include a first conductive layer and a second conductive layer stacked on and spaced apart from first conductive layer. The plurality of first wires may be formed on the first conductive layer, and the plurality of second wires may be formed on the second conductive layer.

In some embodiments, the circuit board may have a first surface, a second surface facing away from the first surface along a thickness direction of the circuit board, and a plurality of via holes penetrating the circuit board along the thickness direction. The plurality of first wires may be spaced apart from each other and arranged on the first surface of the circuit board, and the plurality of second wires may be spaced apart from each other and arranged on the second surface of the circuit board. The coil may further include a plurality of electrical connection members, each of the plurality of electrical connection members may be received in a respective one of the plurality of via holes. Each of the plurality of electrical connection members may electrically connect a respective one of the plurality of first wires and a respective one of the plurality of second wires, enabling the plurality of first wires and the plurality of second wires to be alternately connected in series to each other.

In some embodiments, an angle δ 1 between an extension direction of each of the plurality of first wires and an extension direction of each of the plurality of magnetic sub-members may be in a range of 80° ≤ δ1 ≤ 100°. An angle δ2 between an extension direction of each of the plurality of second wires and the extension direction of each of the plurality of magnetic sub-members may be in a range of 80° ≤ δ2 ≤ 100°.

In a second aspect, the present disclosure provides an inductor including following components.

A magnetic core may be arranged and may include a first magnetic layer and a second magnetic layer insulated from the first magnetic layer. The first magnetic layer may include a plurality of magnetic sub-members. Each of the plurality of magnetic sub-members may extend along a first direction, and the plurality of magnetic sub-members may be spaced apart from each other along a second direction and disposed on a surface of the second magnetic layer. The first direction may intersect the second direction.

A coil may be arranged and may wind around an outer periphery of the magnetic core.

In some embodiments, the coil may be a helical structure, winding around an axial direction. Each of the plurality of magnetic sub-members may have magnetic anisotropy and a first hard axis. An angle α between the first hard axis and the axial direction may be within a range of 0° ≤ α ≤ 20°.

In some embodiments, each of the plurality of magnetic sub-members may have the magnetic anisotropy and the first hard axis. An angle β between the first hard axis and the first direction may be within a range of 0° ≤ β ≤ 20°.

In some embodiments, along the second direction, a width w of each of the plurality of magnetic sub-members may be within a range of 100 µm ≤ w ≤ 500 µm, and a spacing d between adjacent two of the plurality of magnetic sub-members may be within a range of 10 µm ≤ d ≤ 50 µm.

In some embodiments, orthographic projections of all of the plurality of magnetic sub-members onto a surface of the second magnetic layer facing the first magnetic layer has an area s1, and the surface of the second magnetic layer facing the first magnetic layer has an area s2, and 50% ≤ s1/s2 ≤ 98%.

In some embodiments, the second magnetic layer may include N magnetic film sub-layers and at least N-1 insulating sub-layers. The N magnetic film sub-layers and the N-1 insulating sub-layers may be sequentially stacked alternately, and the N ≥ 2 and may be a positive integer. Each of the N magnetic film sub-layers may have magnetic anisotropy and a second hard axis. The coil may be a helical structure, winding around the axial direction. An angle γ between the second hard axis and the axial direction may be within a range of 0° ≤ γ ≤ 20°.

In some embodiments, each of the plurality of magnetic sub-members may have magnetic anisotropy and the first hard axis, and an angle θ between the first hard axis and the second hard axis may be within a range of 0° ≤ θ ≤ 20°.

In a third aspect, the present disclosure provides an electronic device including following components.

A display may be arranged.

The circuit board integrated inductor described in the first aspect or the inductor described in the second aspect of the present disclosure may be arranged.

A processor may be arranged and may be electrically connected to the circuit board integrated inductor or the coil in the circuit board integrated inductor and may be electrically connected to the display. The processor may be configured to control a magnitude and a direction of a current flowing through the coil.

In order to enable any ordinary skilled person in the art to better understand technical solutions of the present disclosure, the technical solutions in the embodiments of the present disclosure will be described clearly and completely below by referring to the accompanying drawings. Apparently, the described embodiments are merely some, but not all, embodiments of the present disclosure. All other embodiments, which are obtained by any ordinary skilled person in the art based on the embodiments of the present disclosure without making creative work, shall fall within the scope of the present disclosure.

Terms of "first," "second," and so on in the specification, claims, and accompanying drawings are used to distinguish objects and do not imply any specific order. Furthermore, terms of "include", "have", and any variations thereof are intended to cover non-exclusive inclusion. For example, a process, a method, a system, a product, or a device including a series of steps or units is not limited to the steps or units listed, but may optionally include steps or units that are not listed, or may optionally include other steps or units that are inherently included in the process, the method, the system, the product, or the device.

The technical solutions in the embodiments of the present disclosure will be described by referring to the accompanying drawings. It should be noted that, for clarity, identical reference numerals denote identical components in the embodiments of the present disclosure. For brevity, detailed descriptions of identical components may be omitted in some embodiments.

As technological development, electronic components are becoming smaller in size, a trend particularly evident in mobile phones and high-performance computing. In these fields, miniaturization has led to a dramatic increase in the number of electronic components, causing greater challenges for power management. Especially for portable electronic devices arranged with batteries, more advanced power management technologies are required. Inductors are critical components in power management circuits, performance and footprint of the inductors significantly influence the overall performance and sizes of the device. To reduce circuit area, inductors having small sizes, high inductance values, low losses, and high operating frequencies are required. By incorporating magnetic cores, inductance may be effectively increased to meet circuit demands, but at the same time, additional losses may be caused. Minimizing the losses may be a key focus.

A solenoid-structured inductor may be similar to a spring, formed by winding a conductive copper wire into coils. A hollow part may be formed by the coil winding, or a magnetic core may be arranged to be wound by the coils. The above configuration has advantages such as high saturation current, low magnetic leakage, and effective utilization of uniaxial anisotropy based on a material of the magnetic core. When high-frequency current flows through the solenoid inductor, according to the Ampere's rule, a direction of a generated magnetic field extends along an axial direction of the solenoid inductor, and that is, a horizontal direction of the magnetic core. An eddy current induced in the magnetic core by the horizontal magnetic field may exist only within a vertical cross section. Finite element simulation of the inductor reveals a slight deviation from an ideal scenario, and that is, the magnetic field generated by the current in wires of the solenoid is not confined to the horizontal direction, and the magnetic field has a vertical component. In this way, the eddy current in a magnetic film is not limited to the vertical cross section but also forms an in-plane eddy current on a surface of the magnetic film, leading to an additional magnetic-core eddy current loss. In this case, the eddy current loss of the inductor may be increased, the efficiency of the inductor may be significantly reduced, causing excessive heating of the inductor.

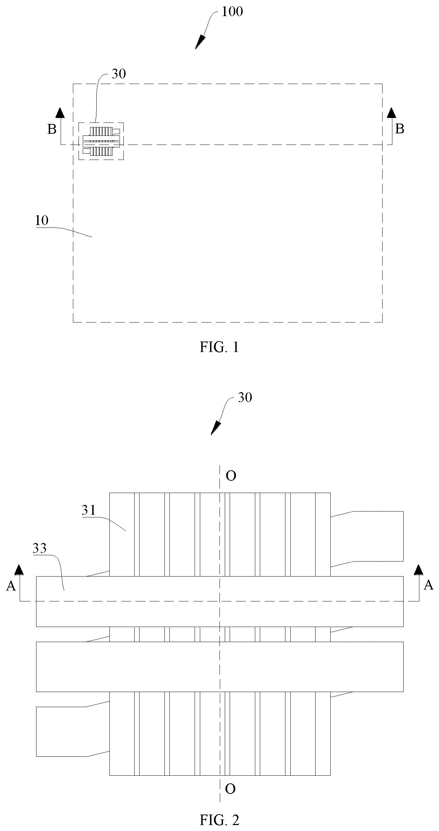

As shown in FIGS. 1 to 4, the present disclosure provides a circuit board integrated inductor 100 including a circuit board 10 and an inductor 30. The inductor 30 may include a magnetic core 31 and a coil 33. The magnetic core 31 may be embedded in the circuit board 10 and may include a first magnetic layer 311 and a second magnetic layer 313. The first magnetic layer 311 may be arranged on and insulated from at least one of two opposite surfaces of the second magnetic layer 313. The first magnetic layer 311 may have a grid pattern. The coil 33 may be at least partially embedded in the circuit board 10 and surround an outer periphery of the magnetic core 31. In other words, the first magnetic layer 311 and the second magnetic layer 313 are insulated from each other.

The circuit board integrated inductor 100 of the present disclosure may be configured in an electronic device. In electronic circuits, the inductor 30 of the circuit board integrated inductor 100 may limit current flow for an alternating current. The inductor 30 and a resistor or a capacitor may cooperatively form a high-pass filter, a low-pass filter, a phase-shift circuit, and a resonant circuit, which may be widely used in various instruments and equipment.

In some embodiments, the circuit board 10 may be a flexible printed circuit board (FPC) or a printed circuit board (PCB), which is not limited herein. In some embodiments, one or more inductors 30 may be integrated on the PCB, for example, one, two, three, four, five inductors 30 may be integrated on the PCB, which is not limited herein. "More than one" refers to two or more, or greater than or equal to two. In some embodiments, the coil 33 of each of the one or more inductors 30 may include one turn or a plurality of turns, such as, but not limited to, one turn, two turns, three turns, four turns, five turns, and so on. As the number of turns of the coil 33 increases, an inductance of the inductor 30 may be larger, under otherwise unchanged conditions. Therefore, the number of turns of the coil 33 may be determined based on application scenarios, an inductance level that needs to be achieved, and other factors. The present disclosure does not limit the number of turns of the coil 33.

The magnetic core 31 may be embedded in the circuit board 10, it may mean that the magnetic core 31 may be embedded to reach an inside of the circuit board 10 and wrapped by the circuit board 10. The coil 33 may be at least partially embedded in the circuit board 10, and in other words, the coil 33 may be embedded in the circuit board 10. Specifically, the coil 33 may be at least partially wrapped by the circuit board 10. Alternatively, the coil 33 and the circuit board 10 may be integrated formed as a one-piece structure. In this case, the coil 33 may be directly formed from conductors in the circuit board 10. During manufacturing the circuit board, the coil 33 may be fabricated simultaneously. Alternatively, the coil 33 may extend through the circuit board 10, meaning that a part of the coil 33 may pass through the circuit board 10, and a part of the coil 33 may be exposed out of the circuit board 10. A material of the coil 33 may be, but not limited to, copper. The coil 33 may surround the outer periphery of the magnetic core 31. It may be understood that the coil 33 may be a helical structure (or solenoid-structured) or may be arranged in a spring-like configuration, surrounding the outer periphery of the magnetic core 31. Alternatively, the coil 33 may be a helical structure or arranged as spring-like configuration, and the magnetic core 31 may be disposed within a space enclosed by the helical or spring-like coil 33. In some embodiments, the coil 33 may be insulated from the magnetic core 31.

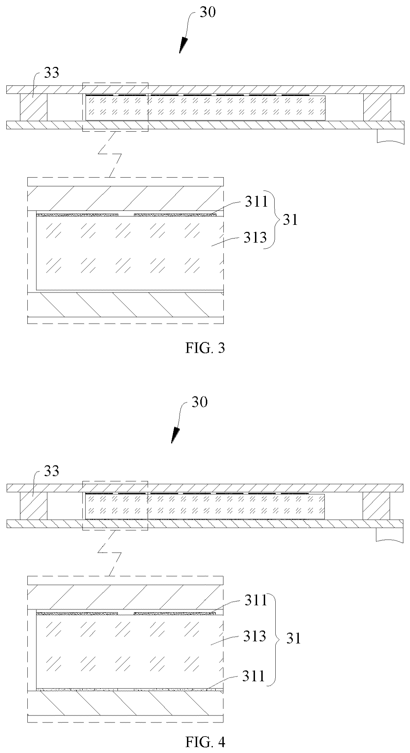

It should be noted that the first magnetic layer 311 may be disposed on and insulated from at least one of the two opposite surfaces of the second magnetic layer 313. It may be understood that the first magnetic layer 311 may include one or two layers. As shown in FIG. 3, when the first magnetic layer 311 includes one layer, the magnetic core 31 may include the second magnetic layer 313 and the first magnetic layer 311 stacked thereon. As shown in FIG. 4, when the first magnetic layer 311 includes two layers, the two layers of the first magnetic layer 311 may be respectively disposed on the two opposite surfaces of the second magnetic layer 313. In other words, in the present embodiment, the magnetic core 31 may include the first magnetic layer 311, the second magnetic layer 313, and the first magnetic layer 311 that are stacked sequentially. Compared to configuration where only one first magnetic layer 311 is arranged on one surface of the second magnetic layer 313, each of the two opposite surfaces of the second magnetic layer 313 being arranged with one first magnetic layer 311 may more effectively reduce the eddy current loss in the inductor 30, so as to improve an efficiency of the inductor 30. In some embodiments, when two first magnetic layers 311 are arranged, orthographic projections of the two first magnetic layers 311 onto the second magnetic layer 313 overlap with each other.

In some embodiments, the first magnetic layer 311 and the second magnetic layer 313 may be stacked along a thickness direction of the circuit board 10. In other words, a plane on which the second magnetic layer 313 extends may be parallel to a plane on which the circuit board 10 extends, and a plane on which the first magnetic layer 311 extends may be parallel to the plane on which the circuit board 10 extends.

The circuit board integrated inductor 100 of the present disclosure may include the circuit board 10 and the inductor 30. The magnetic core 31 of the inductor 30 may be arranged inside the circuit board 10. The coil 33 may be at least partially embedded in the circuit board 10. Compared to the technical solution where the inductor 30 is attached to a surface of the circuit board 10, embedding the inductor 30 may be achieved during manufacturing the circuit board 10, an internal space of the circuit board 10 may be fully utilized, such that an overall thickness of the circuit board integrated inductor 100 may be significantly reduced. When the circuit board integrated inductor 100 is configured in the electronic device, the electronic device may be more miniaturized, and the electronic device may be ultra-thin. Furthermore, the inductor 30 is formed during manufacturing the circuit board 10, and therefore, the inductor 30 may not need to be attached in a separate process, a packaging efficiency may be improved. Soldering for attaching the inductor 30 onto the circuit board 10 may be avoided, circuit connection reliability may be improved, parasitic parameters (such as parasitic capacitance) introduced by attaching the inductor 30 may be eliminated. Furthermore, the inductor 30 may be embedded in the circuit board 10, and a space on the circuit board corresponding to the inductor 30 may be freed up, such that other components may be arranged thereon, a surface area of the circuit board 10 may be saved, routing and component placement capabilities of the circuit board 10 may be improved. Moreover, advantages may be taken from manufacturing the coil 33 in the circuit board 10, a coil 33 of higher turn counts per unit area may be produced. In this way, the inductance of the inductor 30 in the integrated inductor 100 may be improved. Furthermore, the magnetic core 31 in the present embodiment may include the first magnetic layer 311 and the second magnetic layer 313. The first magnetic layer 311 may have the grid pattern. The first magnetic layer 311 of the grid pattern may reduce the eddy current loss in the cross section perpendicular to the magnetic film plane and may reduce the eddy current loss in the magnetic film plane. In this way, the eddy current loss in the inductor 30 on the circuit board integrated inductor 100 may be reduced, and the efficiency of the inductor may be improved. The grid pattern of the first magnetic layer 311 may increase the inductance of the inductor 30. Furthermore, the coil 33 surrounds the outer periphery of the magnetic core 31, and in this way, the inductor 30 may have a highly saturated current and low magnetic leakage, and may effectively take advantages from uniaxial anisotropy of the magnetic core 31.

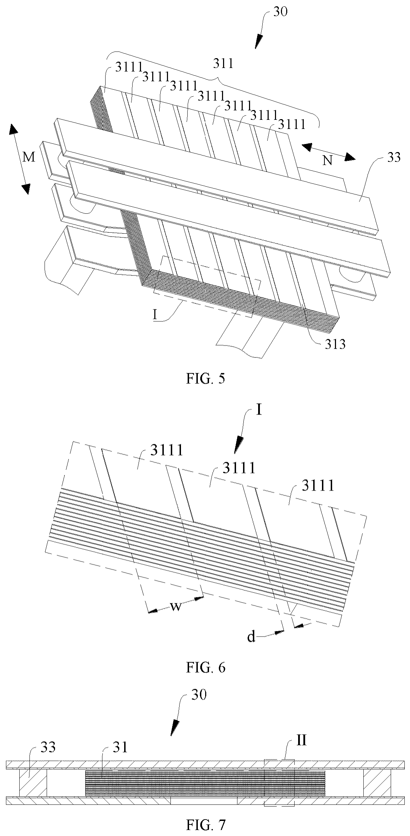

As shown in 5, in some embodiments, the first magnetic layer 311 may include a plurality of magnetic sub-members 3111, each of the plurality of magnetic sub-members 3111 3111 may extend along a first direction (as indicated by an arrow M in FIG. 5). The plurality of magnetic sub-members 3111 may be spaced apart from each other along a second direction (as indicated by an arrow N in FIG. 5) and may be disposed at a side of the second magnetic layer 313. The plurality of magnetic sub-members 3111 may be insulated from the second magnetic layer 313. The first direction may intersect the second direction. It may be understood that the plurality of magnetic sub-members 3111 may form the first magnetic layer 311 having the grid pattern (i.e., a grid magnetic film with a striped pattern or a magnetic film with a striped grid configuration). In some embodiments, the plurality of magnetic sub-members 3111 may form a striped structure or a flat striped structure. In some embodiments, the plurality of magnetic sub-members 3111 may be formed by etching one layer of magnetic material by photolithography or plasma beam etching, and so on.

In an embodiment, the first direction may be perpendicular to the second direction. In this way, the inductor 30 may have a more regular structure and may be small-sized, facilitating the efficiency of the inductor 30 to be improved.

In the present embodiment, the plurality of magnetic sub-members 3111 may form the striped and grid patterned magnetic layer. In this way, the eddy current loss generated by the magnetic field component perpendicular to the plane of the magnetic core 31 may be reduced effectively, copper loss of the inductor 30 may be reduced, and the inductance of the inductor 30 may be may be increased.

As shown in FIG. 6, in some embodiments, a width w of each of the plurality of magnetic sub-members 3111 along the second direction may be in a range of 100 µm ≤ w ≤ 500 µm. Further, the width w of each of the plurality of magnetic sub-members 3111 may be in a range of 150 µm ≤ w ≤ 300 µm. Specifically, the width w of each of the plurality of magnetic sub-members 3111 may be, but not limited to, 100 µm, 125 µm, 150 µm, 175 µm, 200 µm, 225 µm, 250 µm, 275 µm, 300 µm, 325 µm, 350 µm, 375 µm, 400 µm, 425 µm, 450 µm, 475 µm, 500 µm, and so on. The width of each of the plurality of magnetic sub-members 3111 shall neither be excessively wide nor excessively narrow. When the width of each of the plurality of magnetic sub-members 3111 is excessively wide, reduction in the eddy current loss of the inductor 30 may be diminished. When the width of each of the plurality of magnetic sub-members 3111 is excessively narrow, magnetic permeability of the magnetic sub-member 3111 may be reduced, such that the inductance of the inductor 30 may be reduced.

In some embodiments, along the second direction, a spacing d between adjacent two of the plurality of magnetic sub-members 3111 may be in a range of 10 µ m ≤ d ≤ 50 µ m. Specifically, the spacing d between adjacent two of the plurality of magnetic sub-members 3111 may be, but not limited to: 10 µ m, 12 µm, 15 µm, 17 µm, 20 µm, 22 µm, 25 µm, 27 µm, 30 µm, 32 µm, 35 µm, 37 µm, 40 µm, 42 µm, 45 µm, 47 µm, 50 µm, and so on. The spacing between adjacent two of the plurality of magnetic sub-members 3111 may need to be as small as possible. However, when the spacing is excessively small, manufacturing complexity may be improved, and the excessively small spacing may be unfeasible. Conversely, when the spacing is excessively large, an area of the second magnetic layer 313 covered by the plurality of magnetic sub-members 3111 may be excessively small, such that the magnetic permeability may be decreased, and the inductance may be affected.

In some embodiments, a material of the plurality of magnetic sub-members 3111 may include at least one type of soft magnetic material, such as magnetic metals or magnetic alloys. In some embodiments, the magnetic metals may include at least one of: iron, cobalt, or nickel. The magnetic alloys may include at least one of: an iron-based crystalline alloy, an iron-based amorphous alloy, or a cobalt-based amorphous alloy. The iron-based crystalline alloy may include at least one of: a FeNi alloy, a FeCo alloy, a FeAl alloy, a FeSiAl alloy, a FeNiMo alloy, and a FeC alloy. The iron-based amorphous alloy may include at least one of: a FeSiB alloy, a FeB alloy, a FeNiPB alloy, and a FeNiMoB alloy. The cobalt-based amorphous alloy may include at least one of: a CoFeSiB alloy, a CoFeCrSiB alloy, and a CoNiFeSiB alloy.

In some embodiments, an area s1 of an orthographic projection of the first magnetic layer 311 onto a surface of the second magnetic layer 313 facing the first magnetic layer 311 may be s1, an area of the surface of the second magnetic layer 313 facing the first magnetic layer 311 may be s2, and 50% ≤ s1/s2 ≤ 98%. In other words, a total area of orthographic projections of all of the plurality of magnetic sub-members 3111 onto the surface of the second magnetic layer 313 facing the first magnetic layer 311 may be s1, and to the area of the surface of the second magnetic layer 313 facing the first magnetic layer 311 may be s2, and 50% ≤ s1/s2 ≤ 98%. Furthermore, 60% ≤ s1/s2 ≤ 90%. Furthermore, 70% ≤ s1/s2 ≤ 85%. Specifically, a ratio of the s1 to the s2 may be, but not limited to, 50%, 55%, 60%, 65%, 70%, 75%, 80%, 85%, 90%, 94%, 98%, and so on. When the ratio of the s1 to the s2 is excessively small, a proportion of the material of the magnetic core 31 may be decreased, energy stored in the magnetic core 31 may be reduced, and the inductance of the inductor 30 may be reduced. When the ratio of the s1 to the s2 is excessively large, the spacing between the adjacent two of the plurality of magnetic sub-members 3111 may be excessively small, increasing manufacturing complexity and costs.

In some embodiments, the coil 33 may be the helical structure having an axial direction (as indicated by a dashed line O-O in FIG. 2). In other words, the coil 33 may be wound helically around the axial direction. Each of the plurality of magnetic sub-members 3111 may have magnetic anisotropy (i.e., having a hard axis along which magnetization may be achieved highly difficultly and an easy axis along which magnetization may be achieved easily). Each of the plurality of magnetic sub-members 3111 may have a first hard axis. An angle α between the first hard axis and the axial direction may be within a range of 0° ≤ α ≤ 20°. Further, the angle α between the first hard axis and the axial direction may be within a range of 0° ≤ α ≤ 10°. Specifically, the angle α between the first hard axis and the axial direction may be, but is not limited to, 0°, 1°, 2°, 3°, 5°, 7°, 10°, 12°, 14°, 16°, 18°, 20°, and so on.

It should be understood that the axial direction of the coil 33 may be an extension direction of a central axis of a space enclosed by the helical coil 33. It may be understood that the axial direction of the coil 33 may be a direction along which the coil 33 is wound. It may be understood that the axial direction of the coil 33 may be a direction of an internal magnetic flux of the coil 33 when the coil 33 is energized.

In an embodiment, the angle α between the first hard axis and the axial direction may be 0°, and that is, the first hard axis may be parallel to the axial direction. In some embodiments, the axial direction of the coil 33 may be parallel to the extension direction of the circuit board 10.

In the present embodiment, for the helical coil 33, when being energized, magnetic flux lines of the coil may propagate within the coil 33 along nearly one same direction and may be substantially parallel to the axial direction of the coil 33. Coercivity of the hard axis (i.e., the first hard axis) of each magnetic sub-member 3111 may be relatively low, resulting in reduced hysteresis loss. When the angle α between the first hard axis and the axial direction is in a range of 0° to 20°, an increased number of the magnetic flux lines may align along the direction of the first hard axis of the magnetic sub-member 3111. In this way, the magnetic permeability of the first magnetic layer 311 may be reduced, the loss in the inductor 30 may be reduced. When the angle α between the first hard axis and the axial direction is 0°, the hysteresis loss and the eddy current loss of the inductor 30 may be reduced, such that the efficiency of the inductor 30 may be increased. After the magnetic material is magnetized in saturation, when an external magnetic field is reduced to zero, a magnetic flux intensity B does not return to zero. Only by applying a magnetic field of a certain magnitude in a direction opposite to the original magnetization field, the magnetic flux intensity may be reduced to zero, and the applied magnetic field may be referred to as a coercive magnetic field, also known as the coercivity.

In some embodiments, each magnetic sub-member 3111 may have the magnetic anisotropy and the first hard axis. The angle β between the first hard axis and the first direction may be within the range of 0° ≤ β ≤ 20°. In other words, the angle β between the first hard axis and the extension direction of each magnetic sub-member 3111 may be within a range of 0° to 20°. Furthermore, the angle β between the first hard axis and the first direction may be within a range of 0° ≤ β ≤ 10°. Specifically, the angle between the first hard axis and the first direction may be, but not limited to, 0°, 1°, 2°, 3°, 5°, 7°, 10°, 12°, 14°, 16°, 18°, 20°, and so on. In an embodiment, the angle between the first hard axis and the first direction may be 0, and that is, the first hard axis may be parallel to the first direction.

In the present embodiment, the angle between the first hard axis and the first direction may be as small as possible. When the angle is 0°, the magnetic sub-member 3111 may have the lower hysteresis loss, effectively reducing the eddy current loss in the magnetic core 31, improving the efficiency of the inductor 30, and increasing the inductance of the inductor 30.

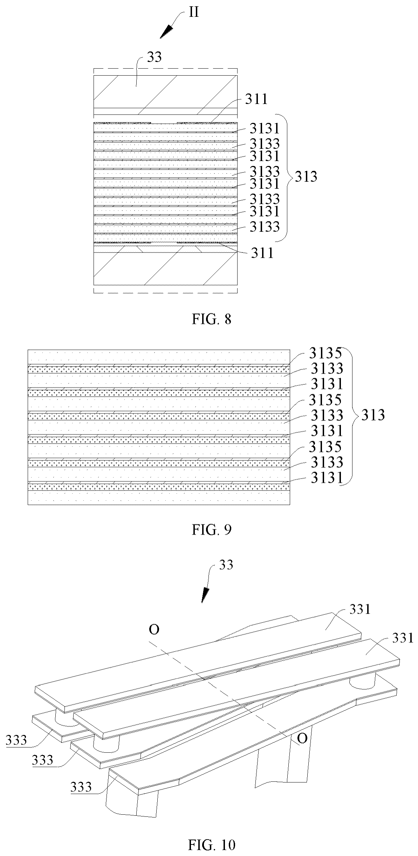

As shown in FIGS. 7 and 8, in some embodiments, the second magnetic layer 313 may include N magnetic film sub-layers 3131 and at least N-1 insulating sub-layers 3133. The N magnetic film sub-layers 3131 and the N-1 insulating sub-layers 3133 may be alternately stacked sequentially along a thickness direction of the circuit board 10, and the N ≥ 2 and may be a positive integer.

When the second magnetic layer 313 includes only a single magnetic film layer, a significant eddy current effect may be generated in the thickness direction of the second magnetic layer 313. In the present embodiment, each of the N magnetic film sub-layer 3131s may be made thinner, and one of the N-1 insulating sub-layers 3133 may be disposed between any adjacent two of the N magnetic film sub-layers 3131. The N-1 insulating sub-layers 3133 may prevent eddy currents in the N magnetic film sub-layers 3131 from propagating through the thickness direction of the second magnetic layer 313, such that the eddy current losses throughout the thickness direction of the entire second magnetic layer 313 may be reduced, the eddy current losses in the entire inductor 30 may be reduced, the efficiency of the inductor 30 may be improved. With a same thickness, compared to a configuration where only a single magnetic film layer is arranged, when at least two magnetic film sub-layers 3131 insulated from each other are sequentially arranged, the eddy current losses within the cross section of the magnetic core 31 may be reduced by 75%.

It may be understood that an extension direction of the N magnetic film sub-layers 3131 may be parallel to the extension direction of the circuit board 10. A stacking direction in which the N magnetic film sub-layers 3131 staked with the N-1 insulating sub-layers 3133 may be perpendicular to the extension direction of the circuit board 10.

In some embodiments, the number of the N magnetic film sub-layers 3131 within the second magnetic layer 313 may be in a range of 2 to 100 layers. Further, the number of the N magnetic film sub-layers 3131 within the second magnetic layer 313 may be in a range of 2 to 30 layers. Specifically, the number of the N magnetic film sub-layers 3131 in the second magnetic layer 313 may be: but not limited to: 2 layers, 3 layers, 5 layers, 8 layers, 10 layers, 20 layers, 30 layers, 40 layers, 50 layers, 60 layers, 70 layers, 80 layers, 90 layers, 100 layers, and so on.

In some embodiments, a thickness h1 of each of the N magnetic film sub-layers 3131 may be in a range of 0.2 µ m ≤ h1 ≤ 10 µ m. In other words, along the stacking direction of the N magnetic film sub-layers 3131 and the N-1 insulating sub-layers 3133, the thickness of each of the N magnetic film sub-layers 3131 may be in a range of 0.2 µm to 10 µm.

Specifically, the thickness h1 of each of the N magnetic film sub-layers 3131 may be, but is not limited to, 0.2 µm, 0.5 µm, 0.8 µm, 1 µm, 1.5 µm, 2 µm, 3 µm, 4 µm, 5 µm, 6 µm, 7 µm, 8 µm, 9 µm, 10 µm, and so on. When the thickness of the magnetic film sub-layer 3131 is excessively small, a proportion of thickness of the N magnetic film sub-layers 3131 in a total thickness of the magnetic core 31 may be excessively low, such that the inductance of the inductor 30 in the circuit board integrated inductor 100 may not be increased. Furthermore, in order to achieve the same total thickness for the magnetic film sub-layers 3131, an increased number of layers may be needed, such that manufacturing complexity and costs may be improved. When the thickness of the magnetic film sub-layer 3131 is excessively large, the eddy current losses in each magnetic film sub-layer 3131 may be increased, and difficulty in a process of depositing the magnetic film sub-layers 3131 may be improved.

In some embodiments, the total thickness h of the N magnetic film sub-layers 3131 within the second magnetic layer 313 may be in a range of 50 µm ≤ h ≤ 500 µm. Specifically, the total thickness h of the N magnetic film sub-layers 3131 within the second magnetic layer 313 may be, but not limited to: 50 µm, 80 µm, 100 µm, 150 µm, 200 µm, 250 µm, 300 µm, 350 µm, 400 µm, 450 µm, 500 µm, and so on. When the total thickness of the N magnetic film sub-layers 3131 within the second magnetic layer 313 is excessively small, the proportion of the magnetic film sub-layers 3131 in the total thickness of the magnetic core 31 may be excessively low, such that the inductance of the inductor 30 in the circuit board integrated inductor 100 may not be increased. Conversely, when the total thickness of the N magnetic film sub-layers 3131 within the second magnetic layer 313 may be excessively large, the manufacturing complexity and costs of the second magnetic layer 313 may be improved.

In some embodiments, the material of the magnetic film sub-layer 3131 may include at least one type of soft magnetic material, such as magnetic metals or magnetic alloys. In some embodiments, the magnetic metals may include at least one of: iron, cobalt, or nickel. The magnetic alloys may include at least one of an iron-based crystalline alloy, an iron-based amorphous alloy, or a cobalt-based amorphous alloy. The iron-based crystalline alloy may include at least one of a FeNi alloy, a FeCo alloy, a FeAl alloy, a FeSiAl alloy, a FeNiMo alloy, and a FeC alloy. The iron-based amorphous alloy may include at least one of a FeSiB alloy, a FeB alloy, a FeNiPB alloy, and a FeNiMoB alloy. The cobalt-based amorphous alloy may include at least one of a CoFeSiB alloy, a CoFeCrSiB alloy, and a CoNiFeSiB alloy.

In some embodiments, along the stacking direction of the N magnetic film sub-layers 3131 and the N-1 insulating sub-layers 3133, the thickness h2 of each of the N-1 insulating sub-layers 3133 may be in a range of 10 µm ≤ h2 ≤ 60 µm. Specifically, the thickness h2 of each insulating sub-layer 3133 may be, but is not limited to, 10 µm, 15 µm, 20 µm, 25 µm, 30 µm, 35 µm, 40 µm, 45 µm, 50 µm, 55 µm, 60 µm, and so on. When the thickness of the insulating sub-layer 3133 is excessively small, mechanical performance may be low, unfavorable for deposition of the N magnetic film sub-layers 3131. When the thickness of the insulating sub-layer 3133 is excessively large, the thickness of the magnetic layer may be increased, such that ultra-thin design of the circuit board integrated inductor 100 may not be achieved.

In some embodiments, each of the N-1 insulating sub-layers 3133 may include at least one of a polyimide film (PI film) and a glass fiber/epoxy resin composite board (Prepreg). The polyimide film may have superior flexibility, and therefore, the polyimide film may be more suitable to be applied to the flexible circuit board 10. The glass fiber/epoxy resin composite board may have better rigidity, and therefore, the glass fiber/epoxy resin composite board may be more suitable to be applied to the printed circuit board 10.

In some embodiments, each of the N magnetic film sub-layers 3131 may have magnetic anisotropy and a second hard axis. The coil 33 may be the helical structure and may have an axial direction. The angle γ between the second hard axis and the axial direction may be within a range of 0° ≤ γ ≤ 20°. Furthermore, the angle γ between the second hard axis and the axial direction may be within a range 0° ≤ γ ≤ 10°. Specifically, the angle γ between the second hard axis and the axial direction may be, but is not limited to, 0°, 1°, 2°, 3°, 5°, 7°, 10°, 12°, 14°, 16°, 18°, 20°, and so on. When the angle γ between the second hard axis and the axial direction is in the range of 0° and 20°, an increased number of magnetic flux lines may align along the second hard axis of the magnetic film sub-layer 3131. In this way, the magnetic permeability of the second magnetic layer 313 may be effectively reduced, the loss in the inductor 30 may be reduced. When the angle γ between the second hard axis and the axial direction is 0°, the hysteresis loss and the eddy current loss of the inductor 30 may be effectively reduced, the efficiency of the inductor 30 may be increased.

In some embodiments, the angle θ between the first hard axis and the second hard axis may be in a range of 0° ≤ θ ≤ 20°. Further, the angle θ between the first hard axis and the second hard axis may be in a range of 0° ≤ θ ≤ 10°. Specifically, the angle θ between the first hard axis and the second hard axis may be, but is not limited to, 0°, 1°, 2°, 3°, 5°, 7°, 10°, 12°, 14°, 16°, 18°, 20°, and so on. When the angle θ between the first hard axis and the second hard axis is in the range of 0° and 20°, an increased number of magnetic flux lines may align along the first hard axis of the magnetic sub-member 3111 and along the second hard axis of the magnetic film sub-layer 3131. In this way, the magnetic permeability of the first magnetic member and the second magnetic layer 313 may be effectively reduced, and the loss in the inductor 30 may be reduced. When the angle θ between the first hard axis and the second hard axis is 0°, the hysteresis loss and the eddy current loss of the inductor 30 may be further reduced, and the efficiency of the inductor 30 may be improved.

In an embodiment, the extension direction of each magnetic sub-member 3111, the first hard axis, the second hard axis, and the axial direction may be parallel to each other. In this way, an increased number of magnetic flux lines may align along the first hard axis of the magnetic sub-member 3111 and along the second hard axis of the magnetic film sub-layer 3131. Therefore, the magnetic permeability of the first magnetic member and the second magnetic layer 313 may be more effectively reduced, the hysteresis loss and the eddy current loss of the inductor 30 may be reduced, and the efficiency of the inductor 30 may be increased. In some embodiments, a length of the magnetic sub-member 3111 along the first direction may be equal to a length of the magnetic film sub-layer 3131 along the first direction.

As shown in FIG. 9, in some embodiments, the second magnetic layer 313 may further include at least N-1 bonding sub-layers 3135. The N-1 insulating sub-layers 3133, the N magnetic film sub-layers 3131, and the N-1 bonding sub-layers 3135 may be stacked alternately sequentially. During preparing the second magnetic layer 313, the magnetic film sub-layer 3131 may be firstly deposited onto the insulating sub-layer 3133 via electroplating. Subsequently, a plurality of insulating sub-layers 3133 may be bonded to each other through a plurality of bonding sub-layers 3135, the magnetic film sub-layer 3131 may be deposited on each of the plurality of insulating sub-layers 3133. In this way, the second magnetic layer 313 may be formed by the plurality of insulating sub-layers 3133, the plurality of magnetic film sub-layers 3131, and the plurality of bonding sub-layers 3135 being alternately arranged. The plurality of bonding sub-layer 3135 may bond the plurality of insulating sub-layers 3133, arranged with the plurality of film sub-layers 3131, to each other, so as to form the second magnetic layer 313 as an integrated one-piece structure. The plurality of bonding sub-layer 3135 may be used to stack the plurality of insulating sub-layer 3133/magnetic film sub-layers 3131, and in this way, a process of assembling the second magnetic layer 313 may be simplified, enabling the plurality of insulating sub-layers 3133/magnetic film sub-layers 3131 to be assembled to each other more stably.

Specifically, the number of the N-1 bonding sub-layers 3135 may be one or a plurality of layers, such as one, two, three, four, five layers, and so on. The number of the N-1 bonding sub-layers 3135 may be determined based on the number of the N magnetic film sub-layers 3131 included in the second magnetic layer 313, which will not be limited herein.

In some embodiments, each of the N-1 bonding sub-layers 3135 may include at least one of: acrylic resin and epoxy resin. The acrylic resin may have high bonding strength and better ductility and flexibility, and therefore, the acrylic resin may may be more suitable to be applied in flexible circuits. However, the acrylic resin may not have ideal electrical performance, copper migration may occur under high-temperature conditions. The epoxy resin may provide better bonding, electrical performance, and corrosion resistance, and therefore, the epoxy resin may have a well-balanced performance profile.

In some embodiments, along a stacking direction in which the N-1 insulating sub-layers 3133, the N magnetic film sub-layers 3131, and the N-1 bonding sub-layers 3135 are stacked, a thickness h3 of each of the N-1 bonding sub-layers 3135 may be in a range of 10 µm ≤ h3 ≤ 30 µm. Specifically, the thickness h3 of each bonding sub-layer 3135 may be, but is not limited to, 10 µm, 12 µm, 14 µm, 16 µm, 18 µm, 20 µm, 22 µm, 24 µm, 26 µm, 28 µm, 30 µm, and so on. When the thickness of the bonding sub-layer 3135 is excessively thin, bonding performance may be insufficient, stability of bonding between magnetic film sub-layers 3131 may be affected. When the thickness of the bonding sub-layer 3135 is excessively large, the thickness of the second magnetic layer 313 may be increased, such that the inductor 30 and the circuit board integrated inductor 100 may not be configured to be ultra-thin.

In some embodiments, the bonding sub-layer 3135 may be a liquid adhesive and may be applied via methods such as coating, spin coating, or squeezing-coating to form a film, and may be heated for curing.

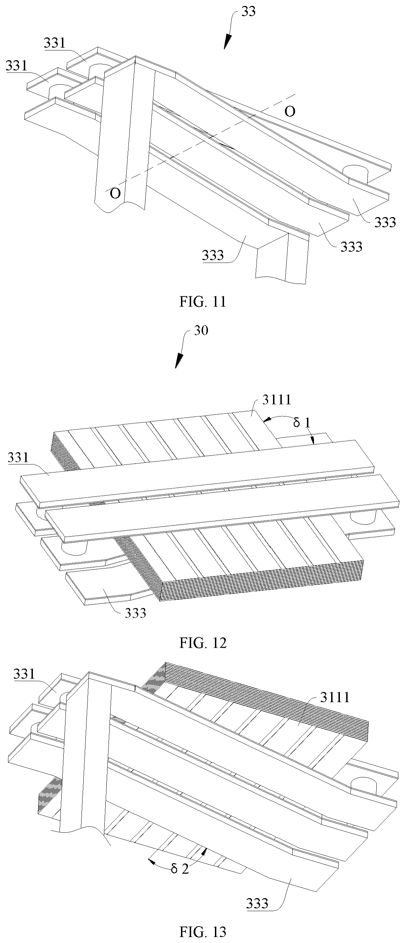

As shown in FIGS. 10 and 11, in some embodiments, the coil 33 may include a plurality of first wires 331 and a plurality of second wires 333. The plurality of first wires 331 may be spaced apart from each other along the extension direction of the circuit board 10 and may be disposed at a same side of the magnetic core 31. The plurality of second wires 333 may be spaced apart from each other along the extension direction of the circuit board 10 and may be disposed at another side of the magnetic core 31 opposite the plurality of first wires 331. The plurality of first wires 331 and the plurality of second wires 333 may be alternately and sequentially connected in series to each other. It may be understood that the plurality of first wires 331 may be arranged on a same layer. The plurality of first wires 331 may be obtained from a same conductive layer by performing processes such as exposure, development, and etching. The plurality of second wires 333 may be arranged on a same layer; the plurality of second wires 333 may be obtained from a same conductive layer by performing processes such as exposure, development, and etching.

For the configuration in which the coil 33 extends along the thickness direction of the circuit board 10, when the coil 33 having a plurality of turns needs to be prepared, the number of needed conductive layers may be the number of turns adding one. That is, when the coil 33 has n turns, n+1 conductive layers may be needed. Therefore, when the coil 33 having the plurality of turns needs to be prepared, the plurality of conductive layers on the circuit board 10 may need to be etched, and the plurality of turns may be obtained by performing a plurality of via-hole processes. In contrast, in the present embodiment, only two conductive layers may be needed to achieve any desired number of turns in the coil 33. In this way, a preparation process for the coil 33 may be simplified. Even when the number of the plurality of turns is large, the thickness of the circuit board 10 may not be increased, such that the circuit board 10 may be made thinner. The number of the plurality of turns of the coil 33 may not be limited by the thickness of the circuit board 10, greater design flexibility may be provided for any number of the plurality of turns of the coil 33.

In some embodiments, the coil 33 may be, but not limited to, a copper coil. In some embodiments, a spacing d1 between adjacent two of the plurality of first wires 331 may be in a range of 20 µm ≤ d1 ≤ 200 µm. Specifically, the spacing d1 between adjacent two of the plurality of first wires 331 may be, but is not limited to, 20 µm, 30 µm, 40 µm, 60 µm, 80 µm, 100 µm, 120 µm, 140 µm, 160 µm, 180 µm, or 200 µm. When the spacing d1 between adjacent two of the plurality of first wires 331 is excessively small, manufacturing complexity may be increased. When the spacing d1 is excessively large, for the same number of turns, a space occupied by the inductor 30 may be increased.

In some embodiments, a thickness of each of the plurality of first wire 331 may be in a range of 10 µm to 100 µm. Specifically, the thickness of the first wire 331 may be, but is not limited to, 10 µm, 20 µm, 30 µm, 40 µm, 50 µm, 60 µm, 70 µm, 80 µm, 90 µm, 100 µm, and so on. When the thickness of the first wire 331 is excessively large, manufacturing complexity may be increased. When the thickness of the first wire 331 is excessively small, a resistance may be excessively large.

In the present disclosure, when referring to a range of a to b, unless otherwise specified, it indicates any value within the range of a to b, and the value a and the value b are included.

In some embodiments, a width of each of the plurality of first wires 331 may be in a range of 50 µm to 500 µm. Specifically, the width of the first wire 331 may be, but not limited to, 50 µm, 60 µm, 70 µm, 80 µm, 90 µm, 100 µm, 150 µm, 200 µm, 250 µm, 300 µm, 350 µm, 400 µm, 450 µm, 500 µm, and so on. When the width of the first wire 331 is excessively large, the width of the inductor 30 may be excessively large. When the width of the first wire 331 is excessively small, the resistance may be excessively large.

In some embodiments, a spacing d2 between adjacent two of the plurality of second wires 333 may be within a range of 20 µm ≤ d2 ≤ 200 µm. Specifically, the spacing d2 between adjacent two of the plurality of second wires 333 may include, but not limited to 20 µm, 30 µm, 40 µm, 60 µm, 80 µm, 100 µm, 120 µm, 140 µm, 160 µm, 180 µm, and 200 µm. When the spacing d2 between adjacent two of the plurality of second wires 333 is excessively small, manufacturing complexity may be increased. When the spacing d2 is excessively large, with the same number of turns in the coil, the space occupied by the inductor 30 may be increased.

In some embodiments, the thickness of the second wire 333 may be in a range of 10 µm to 100 µm. Specifically, the thickness of the second wire 333 may be, but is not limited to, 10 µm, 20 µm, 30 µm, 40 µm, 50 µm, 60 µm, 70 µm, 80 µm, 90 µm, 100 µm, and so on. When the thickness of the second wire 333 is excessively large, manufacturing complexity may be increased. When the thickness is excessively small, the resistance may be excessively large.

In some embodiments, the width of each of the plurality of second wires 333 may be in a range of 50 µm to 500 µm. Specifically, the width of the second wire 333 may include, but not limited to 50µm, 60µm, 70µm, 80µm, 90µm, 100µm, 150µm, 200µm, 250µm, 300µm, 350µm, 400µm, 450µm, 500µm, and so on. When the width of the second wire 333 is excessively large, the width of the inductor 30 may be excessively large. When the width of the second wire 333 is excessively small, the resistance may be excessively large.

As shown in FIG. 12, in some embodiments, an angle δ 1 between the extension direction of the first wire 331 and the extension direction of the magnetic sub-member 3111 (i.e., the first direction) may be in a range of 80° ≤ δ 1 ≤ 100° . Specifically, the angle δ 1 between the extension direction of the first wire 331 and the extension direction of the magnetic sub-member 3111 (i.e., the first direction) may be, but not limited to, 80°, 83°, 85°, 88°, 90°, 92°, 95°, 98°, 100°, and so on. As the extension direction of the first wire 331 tends to be perpendicular to the extension direction of the magnetic sub-member 3111, when the coil 33 is energized, an extending direction of magnetic flux lines of the first wire 331 may be better aligned with that of the magnetic sub-member 3111. In this way, the first hard axis of the magnetic sub-member 3111 may be more precisely controlled, such that the hysteresis loss in the first magnetic layer 311 may be reduced, and the efficiency of the inductor 30 may be improved.

As shown in FIG. 13, in some embodiments, an angle δ2 between an extension direction of the second wire 333 and the extension direction of the magnetic sub-member 3111 (i.e., the first direction) may be within a range of 80° ≤ δ2 ≤ 100°. Specifically, the angle δ2 between the extension direction of the second wire 333 and the extension direction of the magnetic sub-member 3111 (i.e., the first direction) may be, but not limited to, 80°, 83°, 85°, 88°, 90°, 92°, 95°, 98°, 100°, and so on. As the extension direction of the second wire 333 tends to be perpendicular to the extension direction of the magnetic sub-member 3111, when the coil 33 is energized, an extending direction of magnetic flux lines of the second wire 333 may be better aligned with that of the magnetic sub-member 3111. In this way, the first hard axis of the magnetic sub-member 3111 may be more precisely controlled, such that the hysteresis loss in the first magnetic layer 311 may be reduced, and the efficiency of the inductor 30 may be improved.

In an embodiment, at least one of the first wire 331 and the second wire 333 may be perpendicular to the extension direction of the magnetic sub-member 3111.

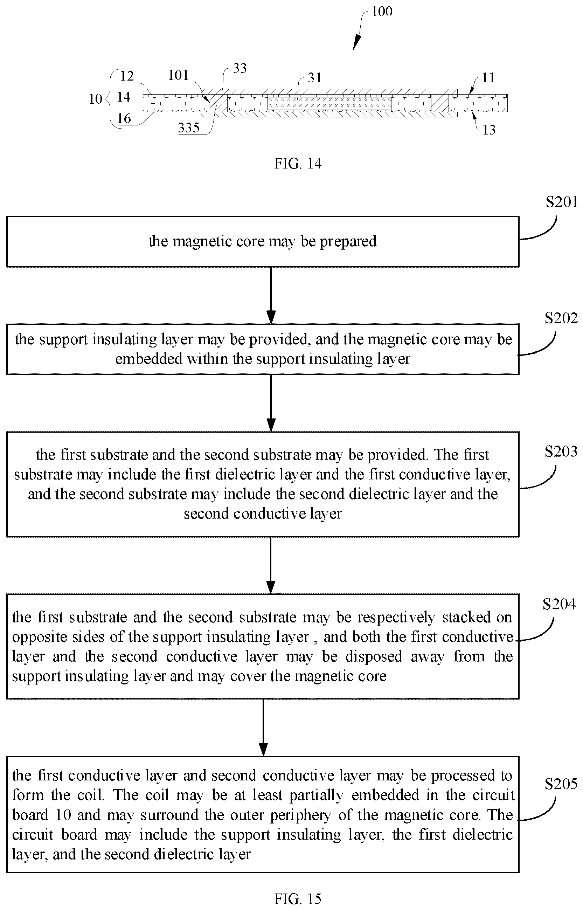

As shown in FIG. 14, in some embodiments, the circuit board 10 may have the first surface 11, the second surface 13 facing away from the first surface 11 along the thickness direction of the circuit board 10, and a plurality of via holes 101 extending through the circuit board 10 along the thickness direction. The plurality of first wires 331 may be spaced apart from each other and arranged on the first surface 11 of the circuit board 10. The plurality of second wires 333 may be spaced apart from each other and arranged on the second surface 13 of the circuit board 10. The coil 33 may further include a plurality of electrical connection members 335. Each of the plurality of electrical connection members 335 may be received in a respective one of the plurality of via holes 101 and may electrically connect a respective one of the plurality of first wires 331 with a respective one of the plurality of second wires 333. In this way, the plurality of first wires 331 and the plurality of second wires 333 may be alternately connected to each other in series. The coil 33 is formed by sequentially connecting the plurality of first wires 331 on the first surface 11 and the plurality of second wires 333 on the second surface 13 of the circuit board 10 through the plurality of via holes 101 using copper plating. In this way, the coil 33 may be formed during preparing the circuit board 10, and no additional preparation process for the coil 33 is needed, such that the preparation process for the circuit board integrated inductor 100 may be simplified.

In some embodiments, the coil 33 may be formed during the manufacturing process of the circuit board 10. It may be understood that the coil 33 and the circuit board 10 may be integrally formed with each other. The coil 33 may be formed from the conductive layer on the circuit board 10 by performing processes such as exposure, development, etching, and stripping. In this way, the coil 33 may be formed during preparing circuits on the circuit board 10, and no additional preparation process for the coil 33 is needed, such that the preparation process for the circuit board integrated inductor 100 may be simplified.

The circuit board integrated inductor 100 of the present disclosure may be prepared by performing a method as described in the following embodiments. Alternatively, the circuit board integrated inductor 100 may be prepared by other methods. The present disclosure provides one or more preparation methods for the circuit board integrated inductor 100 of the present disclosure, which shall not be interpreted as limiting the circuit board integrated inductor 100 of the present disclosure.

As shown in FIG. 15, the present disclosure further provides a method for preparing the circuit board integrated inductor 100. The circuit board integrated inductor 100 may include the circuit board 10 and the inductor. The inductor may include the coil 33 and the magnetic core 31. The magnetic core 31 may include the first magnetic layer 311 and the second magnetic layer 313. The circuit board 10 may include the first substrate 12, the support insulating layer 14, and the second substrate 16 that are stacked sequentially (as shown in FIG. 14). The method may include following blocks.

In a block S201, the magnetic core 31 may be prepared.

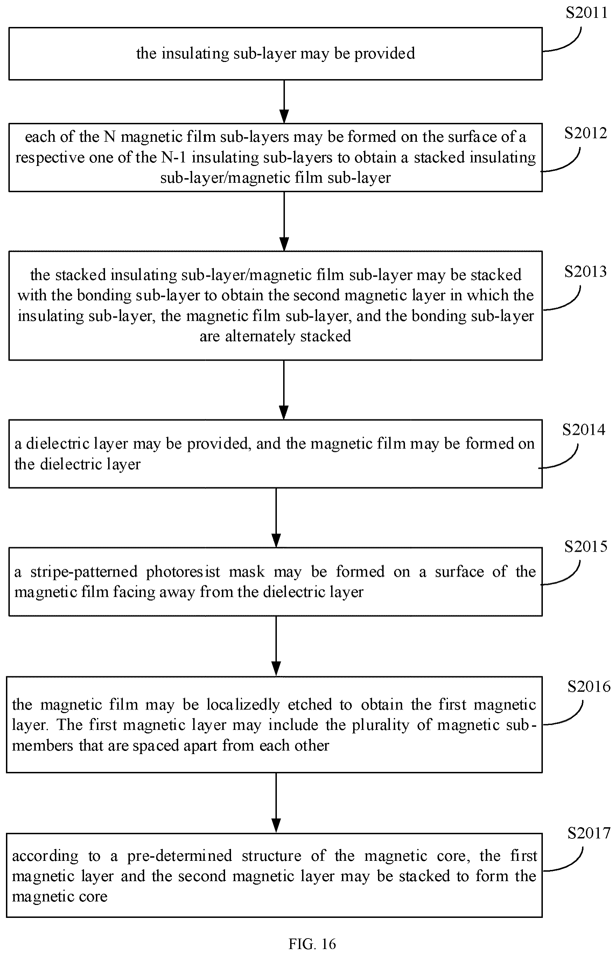

As shown in FIG. 16, in some embodiments, preparing the magnetic core 31 may include following blocks.

In a block S2011, the insulating sub-layer 3133 may be provided.

Detailed description of the insulating sub-layer 3133 may be referred to the above description for the embodiments, which will not be repeated herein.

In a block S2012, each of the N magnetic film sub-layers 3131 may be formed on the surface of a respective one of the N-1 insulating sub-layers 3133 to obtain a stacked insulating sub-layer 3133/magnetic film sub-layer 3131.

In some embodiments, the magnetic film sub-layer 3131 may be deposited onto the surface of the insulating sub-layer 3133 via processes such as electroplating or sputtering, such that stacked configuration of the insulating sub-layer 3133/magnetic film sub-layer 3131 may be formed. Detailed description of the magnetic film sub-layer 3131 may be referred to the description for the above embodiments, which will not be repeated herein. In some embodiments, each of the two opposite surfaces of the insulating sub-layer 3133 may be arranged with one magnetic film sub-layer 3131, such that stacked configuration of the magnetic film sub-layer 3131/insulating sub-layer 3133/magnetic film sub-layer 3131 may be formed. During lamination of multiple layers at a later stage, one insulating sub-layer 3133 may be disposed between two stacked configurations of the magnetic film sub-layer 3131/insulating sub-layer 3133/magnetic film sub-layer 3131. The following embodiments will be described based on one magnetic film sub-layer 3131 formed on one surface of the insulating sub-layer 3133. In some embodiments, during electroplating, a magnetic field may be applied to enable the magnetic film sub-layer 3131 to have the uniaxial anisotropy (i.e., magnetic anisotropy), i.e., enabling the magnetic film sub-layer 3131 to have the second hard axis

In a block S2013, the stacked insulating sub-layer 3133/magnetic film sub-layer 3131 may be stacked with the bonding sub-layer 3135 to obtain the second magnetic layer 313 in which the insulating sub-layer 3133, the magnetic film sub-layer 3131, and the bonding sub-layer 3135 are alternately stacked.

In some embodiments, based on the pre-determined number of magnetic film sub-layers 3131, the stacked insulating sub-layer 3133/magnetic film sub-layer 3131 and the bonding sub-layer 3135 (such as a bonding film) may be sequentially laminated and hot-pressed, such that a plurality of stacked configurations of the insulating sub-layer 3133/magnetic film sub-layer 3131 may be bonded to each other. In this way, the second magnetic layer 313 in which the insulating sub-layer 3133, the magnetic film sub-layer 3131, and the bonding sub-layer 3135 are arranged alternately may be formed. Detailed structures of the second magnetic layer 313 and the bonding sub-layer 3135 may be referred to the description for the above embodiments, which will not be limited herein.

In a block S2014, a dielectric layer (not shown in the drawing) may be provided, and the magnetic film may be formed on the dielectric layer.

In some embodiments, the magnetic film may be deposited on the surface of the dielectric layer by performing processes such as electroplating. In some embodiments, the dielectric layer may be insulating and may include, but not limited to, at least one of a polyimide layer, a glass fiber/epoxy composite board, and so on. In some embodiments, during electroplating, a magnetic field may be applied to enable the magnetic film to have the uniaxial anisotropy (i.e., magnetic anisotropy).

In a block S2015, a stripe-patterned photoresist mask may be formed on a surface of the magnetic film facing away from the dielectric layer (not shown in the drawing).

In some embodiments, a spin coater may be used to spin-coat a photoresist solution onto the surface of the magnetic film facing away from the dielectric layer. The coating may be baked to remove solvents, forming the photoresist layer. In other embodiments, the photoresist layer may be directly adhered and may be placed in a photolithography machine, localized exposure may be performed on the photoresist layer according to a pre-determined pattern. Development with a developer solution may be performed to form the strip and grid patterned photoresist mask.

In a block S2016, the magnetic film may be localizedly etched to obtain the first magnetic layer 311. The first magnetic layer 311 may include the plurality of magnetic sub-members 3111 that are spaced apart from each other.

In some embodiments, the strip and grid patterned photoresist mask may extend along the hard axis of the magnetic film, such that the first hard axis of the magnetic sub-member 3111 may be the same as the extension direction of the magnetic sub-member 3111. In some embodiments, a strong acid etchant may be used to etch a region of the magnetic film that is not protected by the photoresist mask. The photoresist mask may be removed to obtain the first magnetic layer 311 in which the plurality of stripped magnetic sub-members 3111 are spaced apart from each other. In other embodiments, the first magnetic layer 311 may be etched by an ion beam, which will not be limited herein.

A sequence of preparing the first magnetic layer 311 and preparing the second magnetic layer 313 may be reversed, which will not be limited herein. That is, blocks S2014 to S2016 may be performed prior to blocks S2011 to S2013.

In a block S2017, according to a pre-determined structure of the magnetic core 31, the first magnetic layer 311 and the second magnetic layer 313 may be stacked to form the magnetic core 31.

In some embodiments, each of the two opposite surfaces of the second magnetic layer 313 may be arranged with one first magnetic layer 311. An adhesive material may be used, and hot pressing may be performed to bond the first magnetic layer 311 with the second magnetic layer 313. In some embodiments, when the first magnetic layer 311 and the second magnetic layer 313 are stacked, pre-determined circular holes may be used for alignment. In this way, the first hard axis of the magnetic sub-member 3111 or the extension direction of the magnetic sub-member 3111 may be the same as (i.e., parallel or aligned to) the second hard axis of the second magnetic layer 313.

In some embodiments, an insulating layer may be disposed between the first magnetic layer 311 and the second magnetic layer 313 to electrically isolate the first magnetic layer 311 from the second magnetic layer 313. A material of the insulating layer may be the same as or different from that of the insulating sub-layer 3133 or the dielectric layer, which will not be limited herein.

In some embodiments, providing the magnetic core 31 may further include a block S2018, wherein laser cutting or die-cutting may be performed to obtain the magnetic core 31 having predetermined dimensions. For example, cutting may be performed to obtain the magnetic core 31 having a length in a range of 0.5 mm to 5 mm and a width in a range of 0.5 mm to 5 mm.

During cutting, attention must be paid to a cutting direction, so as to ensure the first hard axis of the magnetic core 31 to be the same as the second hard axis and the winding direction of the coil 33 in the inductor 30 (i.e., the axial direction of the inductor 30).

In a block S202, the support insulating layer 14 may be provided, and the magnetic core 31 may be embedded within the support insulating layer 14.

In some embodiments, laser or mechanical drilling may be performed to form a receiving hole and a first positioning hole in the support insulating layer 14, and the magnetic core 31 may be arranged inside the receiving hole. In some embodiments, a size of the receiving hole may be comparable to a size of the magnetic core 31, such that when the magnetic core 31 is received in the receiving hole, the magnetic core 31 may abut against a hole wall of the receiving hole. In some embodiments, one or a plurality of receiving holes may be formed. When the plurality of receiving holes are formed, the plurality of receiving holes may be spaced apart from each other. The number of the receiving holes may be determined based on the number of inductors 30, which will not be limited herein.

In a block S203, the first substrate 12 and the second substrate 16 may be provided. The first substrate 12 may include the first dielectric layer and the first conductive layer, and the second substrate 16 may include the second dielectric layer and the second conductive layer.

In some embodiments, a second positioning hole may be formed in the first substrate 12 at a position corresponding to the first positioning hole in the support insulating layer 14. A third positioning hole may be formed in the second substrate 16 at a position corresponding to the first positioning hole in the support insulating layer 14. In some embodiments, the first substrate 12 may be, but not limited to, a single-sided copper-clad laminate, and the second substrate 16 may be, but not limited to, a single-sided copper-clad laminate. In some embodiments, the first dielectric layer may be, but not limited to, a polyimide film (PI film) or a glass fiber/epoxy resin composite board (prepreg board). The second dielectric layer may be, but not limited to, a polyimide film (PI film) or a glass fiber/epoxy resin composite board (prepreg board). The first conductive layer may be, but not limited to, a copper layer; and the second conductive layer may be, but not limited to, a copper layer.

In a block S204, the first substrate 12 and the second substrate 16 may be respectively stacked on opposite sides of the support insulating layer 14, and both the first conductive layer and the second conductive layer may be disposed away from the support insulating layer 14 and may cover the magnetic core 31.

In some embodiments, positioning may be achieved based on the first positioning hole, the second positioning hole, and the third positioning hole. The first substrate 12, the second substrate 16, and the support insulating layer 14 having the magnetic core 31 may be stacked sequentially and pressed to each other.

In a block S205, the first conductive layer and second conductive layer may be processed to form the coil 33. The coil 33 may be at least partially embedded in the circuit board 10 and may surround the outer periphery of the magnetic core 31. The circuit board 10 may include the support insulating layer 14, the first dielectric layer, and the second dielectric layer.

In some embodiments, the first conductive layer may be subjected to exposure, development, etching, and masking to obtain the plurality of first wires 331 that are spaced apart from each other. The plurality of first wires 331 may be arranged in parallel to each other and spaced apart from each other at an equal interval. Via holes may be formed in the first substrate 12, the support insulating layer 14, and the second substrate 16. A conductive material (such as copper) may be deposited in the via holes to in-series connect the plurality of first wires 331 with the plurality of second wires 333 alternately. In this way, the coil 33, which is the helical structure and has the plurality of turns surrounding the outer periphery of the magnetic core 31, may be formed.

It is understood that the circuit board 10 may include the first conductive layer and the second conductive layer stacked on and spaced apart from the first conductive layer. The plurality of first wires 331 may be formed on the first conductive layer, and the plurality of second wires 333 may be formed on the second conductive layer.

The circuit board integrated inductor 100 provided by the present disclosure will be further described below.

### Embodiment 1

In the present embodiment, a size of the magnetic core 31 may be 2.925 mm × 2.26 mm × 0.32 mm (length × width × height). The magnetic core 31 may include the first magnetic layer 311, the second magnetic layer 313, and another first magnetic layer 311 that are stacked sequentially. A thickness of the first magnetic layer 311 (i.e., the magnetic sub-member 3111) may be 2 µm. The second magnetic layer 313 may include 12 insulating sub-layers 3131 that are insulated from each other. Each of the 12 insulating sub-layers 3131 may have a thickness of 2 µm (i.e., the magnetic core 31 in the present embodiment may include 12 insulating sub-layers 3131 and two first magnetic layers 311). The coil 33 may be made of copper, a line width of the coil 33 may be 400 µm, a thickness of the coil 33 may be 60 µm, a pitch of the coil 33 may be 120 µm, and the coil 33 may have 2.5 turns. Both the magnetic sub-member 3111 and the magnetic film sub-layer 3131 may be made of FeNi soft magnetic alloy, having relative magnetic permeability of 280 and electrical conductivity of 2353 kS/m. The length of the magnetic sub-member 3111 along the first direction may be equal to the length of the magnetic film sub-layer 3131 along the first direction, and an end of the magnetic sub-member 3111 may be stacked on an end of the magnetic film sub-layer 3131. The length of the magnetic sub-member 3111 along the first direction and the length of the magnetic film sub-layer 3131 along the first direction may both be 2.26 mm. The magnetic sub-component 3111 may have a width of 200 µm. A spacing between adjacent two of the plurality of magnetic sub-members 3111 may be 40 µm. The insulating sub-layer 3133 may be made of PI, and the bonding sub-layer 3135 may be made of epoxy resin. A total thickness of the PI and the bonding sub-layer 3135 may be 12 µm.

### Embodiment 2

Being different from the Embodiment 1, in the Embodiment 2, the first magnetic layer 311 may be arranged on only one surface of the second magnetic layer 313, i.e., only one first magnetic layer 311 may be arranged. The magnetic core 31 may include 12 magnetic film sub-layers 3131 and one first magnetic layer 311. All other parameters in the Embodiment 2 may be identical to those in the Embodiment 1.

### Control Embodiment 1

Being different from the Embodiment 1, in the Control Embodiment 1, only the second magnetic layer 313 may be arranged. The magnetic core 31 may include only the 12 magnetic film sub-layers 3131. All other parameters in the Control Embodiment 1 may be identical to those in the Embodiment 1 and the Embodiment 2.

### Control Embodiment 2

Being different from the Embodiment 1, in the Control Embodiment 2, only the second magnetic layer 313 may be arranged. The magnetic core 31 may include only 14 magnetic film sub-layers 3131. All other parameters in the Control Embodiment 2 may be identical to those in the Embodiment 1 and the Embodiment 2.

### Control Embodiment 3

Being different from the Embodiment 1, in the Control Embodiment 3, only the second magnetic layer 313 may be arranged, and the magnetic core 31 may include only 13 magnetic film sub-layers 3131. All other parameters in the Control Embodiment 2 may be identical to those in the Embodiment 1 and the Embodiment 2.

Simulation calculations may be performed according to the standard GB/T 8554-1998, performance data for the circuit board integrated inductor 100 of the Embodiment 1, the circuit board integrated inductor 100 of the Embodiment 2, and the circuit board integrated inductors 100 of the Control Embodiments 1 to 3, at an operating frequency of 10 MHz and an operating current of 1 A, are obtained and are shown in Table 1 below.

**Table 1: Performance Data Of Circuit Board Integrated Inductor 100 Obtained From Each Embodiment And Each Control Embodiment**

| Embodim ents | The number of first magnetic layers 311 | The number of magnetic film sub-layers 3131 | Inductance (nH) | Total copper loss (mW) | Alternating current copper loss of coil 33 (mW) | Eddy current loss (mW) |
|---|---|---|---|---|---|---|
| Embodi ment 1 | 2 | 12 | 15.13 | 23.75 | 11.04 | 12.71 |
| Embodi ment 2 | 1 | 12 | 14.75 | 25.05 | 12.16 | 12.88 |
| Control Embodi ment 1 | 0 | 12 | 14.41 | 25.87 | 10.48 | 15.39 |
| Control Embodi ment 2 | 0 | 14 | 15.25 | 29.07 | 12.42 | 16.65 |
| Control Embodi ment 3 | 0 | 13 | 14.80 | 27.80 | 12.22 | 15.58 |

According to results shown in Table 1 and according to the results of the Embodiment 1 and the Control Embodiment 1, by arranging an additional one layer of the first magnetic layer 311 (i.e., the strip and grid patterned magnetic film) to each of the two opposite surfaces of the second magnetic layer 313, the inductance of the inductor 30 in the circuit board integrated inductor 100 may be increased. In addition, the eddy current loss and the total copper loss of the coil 33 may be reduced. In the Embodiment 1, the 12 magnetic film sub-layers 3131 and two first magnetic layers 311 (two strip and grid patterned magnetic films) may be arranged. In the Control Embodiment 2, the 14 magnetic film sub-layers 3131 may be arranged. According to the results of the Embodiment 1 and the Control Embodiment 2, the inductance of the circuit board integrated inductor 100 of the Embodiment 1 may be comparable to the inductance of the circuit board integrated inductor 100 of the Control Embodiment 2. However, in the Embodiment 1 in which the grid patterned magnetic film is arranged, the eddy current loss, the AC copper loss, and the total copper loss may be lower. Therefore, compared to a configuration where all film layers are intact and non-patterned magnetic films, the grid-patterned magnetic film may enable the circuit board integrated inductor 100 to maintain high inductance and to have effectively-reduced eddy current loss, AC copper loss, and total copper loss.

In the Embodiment 2, the 12 magnetic film sub-layers 3131 and one first magnetic layer 311 (one strip and grid patterned magnetic film layer) may be arranged. In the Control Embodiment 3, the 13 magnetic film sub-layers 3131 may be arranged. According to the results of the Embodiment 2 and the Control Embodiment 3, by arranging the first magnetic layer 311 (i.e., strip and grid patterned magnetic film) on the surface of the second magnetic layer 313, the eddy current loss, the AC copper loss, and the total copper loss in the circuit board integrated inductor 100 may be reduced. However, compared to the configuration in which only one first magnetic layer 311 is arranged, when two grid patterned first magnetic layers 311 are arranged, reduction in the eddy current loss, the AC copper loss, and the total copper loss of the circuit board integrated inductor 100 may be greater.

As shown in FIGS. 2 to 4, the present disclosure further provides an inductor 30 including the magnetic core 31 and the coil 33. The magnetic core 31 may include the first magnetic layer 311 and the second magnetic layer 313. The first magnetic layer 311 may be insulated from and disposed on at least one of the two opposite surfaces of the second magnetic layer 313. The first magnetic layer 311 may have the grid pattern. The coil 33 may surround the outer periphery of the magnetic core 31. In other words, the first magnetic layer 311 and the second magnetic layer 313 may be insulated from each other.

The inductor 30 of the present disclosure may be configured in an electronic device. In an electronic circuit, the inductor 30 may limit the current flow of the alternating current. The inductor 30 and the resistor or the capacitor may cooperatively form a high-pass filter, a low-pass filter, a phase-shift circuit, and a resonant circuit, which may be widely arranged in various instruments and equipment.

The magnetic core 31 of the inductor 30 in the present disclosure may include the first magnetic layer 311 and the second magnetic layer 313. The first magnetic layer 311 may have the grid pattern. The grid-patterned first magnetic layer 311 may reduce the eddy current loss in the cross section that is perpendicular to the magnetic film plane and may reduce the eddy current loss in the magnetic film plane. In this way, the eddy current loss of the inductor 30 may be greatly reduced, and the efficiency of the inductor 30 may be increased. The grid-patterned first magnetic layer 311 may increase the inductance of the inductor 30. Furthermore, the coil 33 surrounds the outer periphery of the magnetic core 31, and in this way, the inductor 30 may have a highly-saturated current and low leakage flux, such that the uniaxial anisotropy and other advantages of the magnetic core 31 may be effectively utilized.

As shown in FIGS. 5 and 6, in some embodiments, the first magnetic layer 311 may include the plurality of magnetic sub-members 3111. Each magnetic sub-member 3111 may extend along the first direction. The plurality of magnetic sub-members 3111 may be spaced apart from each other along the second direction and arranged on the surface of the second magnetic layer 313. The first direction may intersect the second direction. It may be understood that the plurality of magnetic sub-members 3111 may form the grid-patterned first magnetic layer 311 (i.e., the strip and grid patterned magnetic film). In the present embodiment, the plurality of magnetic sub-members 3111 may form the strip and grid patterned magnetic layer. In this way, the eddy current loss generated by the magnetic field component perpendicular to the plane of the magnetic core 31 may be reduced, and the copper loss in the inductor 30 may be reduced, and the inductance of the inductor 30 may be increased.

In some embodiments, along the second direction, the width w of each magnetic sub-member 3111 may be in the range of 100 µ m ≤ w ≤ 500 µ m. The width w of the magnetic sub-member 3111 may neither be excessively wide nor excessively narrow. When the width w is excessively wide, the reduction in the eddy current loss of the inductor 30 may be diminished. When the width w is excessively narrow, the magnetic permeability of the magnetic sub-member 3111 may be reduced, such that the inductance of the inductor 30 may be reduced.

In some embodiments, the spacing d between adjacent two of the plurality of magnetic sub-members 3111 may be in the range of 10 µ m ≤ d ≤ 50 µ m. The spacing between the adjacent two magnetic sub-members 3111 may be as small as possible. However, when the spacing is excessively small, manufacturing complexity may be increased, and manufacturing the excessively small spacing may be unfeasible. When the spacing d between the adjacent two magnetic sub-member 3111 is excessively large, the area of the second magnetic layer 313 covered by each magnetic sub-member 3111 may be excessively small, leading to decrease in the magnetic permeability and affecting the inductance.

Detailed description of other aspects of the first magnetic layer 311 and the magnetic sub-members 3111 may be referred to the corresponding embodiments in the above, which will not be repeated herein.

In some embodiments, the coil 33 may be the helical structure and may have the axial direction (i.e., the coil 33 is wound helically around the axial direction). Each magnetic sub-member 3111 may have the magnetic anisotropy and the first hard axis. The angle α between the first hard axis and the axial direction may be in the range of 0° ≤ α ≤ 20°. When the helical coil 33 is energized, magnetic flux lines may propagate within the coil 33 along one direction, which may be substantially parallel to the axial direction. The coercivity of the hard axis of the magnetic sub-member 3111 (i.e., the first hard axis) may be relatively low, resulting in reduced hysteresis loss. When the angle α between the first hard axis and the axial direction is within the range of 0° to 20°, an increased number of magnetic flux lines may align along the first hard axis of the magnetic sub-member 3111. In this way, the magnetic permeability of the first magnetic layer 311 may be effectively reduced, lowering the loss in the inductor 30. When angle α between the first hard axis and the axial direction is 0°, the hysteresis loss and the eddy current loss of the inductor 30 may further be reduced, enabling the inductor 30 to achieve a higher efficiency.

In some embodiments, the angle β between the first hard axis and the first direction may be within the range of 0° ≤ β ≤ 20°. The angle between the first hard axis and the first direction may be as small as possible. When the angle is 0°, the magnetic sub-member 3111 may have a lower hysteresis loss, the eddy current loss in the magnetic core 31 may be effectively reduced, and the efficiency of the inductor 30 may be further increased.

As shown in FIGS. 7 and 8, in some embodiments, the second magnetic layer 313 may include the N magnetic film sub-layers 3131 and at least N-1 insulating sub-layers 3133. The N magnetic film sub-layers 3131 and the at least N-1 insulating sub-layers 3133 may be stacked alternately sequentially. The N ≥ 2 and may be a positive integer. When only one second magnetic layer 313 is arranged, a significant eddy current effect may be generated in the thickness direction of the second magnetic layer 313. In the present embodiment, each magnetic film sub-layer 3131 may be made thinner, and one of the at least N-1 insulating sub-layers 3133 may be disposed between any adjacent two of the N magnetic film sub-layers 3131. The insulating sub-layer 3133 may prevent conduction of the eddy current in the magnetic film sub-layers 3131 along the thickness direction of the second magnetic layer 313, such that the eddy current loss across the entire thickness of the second magnetic layer 313 may be reduced, and the efficiency of the inductor 30 may be improved. With the same thickness, compared to the configuration in which only one magnetic film layer is arranged, arranging at least two magnetic film sub-layers 3131 sequentially and insulated from each other may reduce the eddy current loss in the cross section of the magnetic core 31 by 75%.

In some embodiments, the magnetic film sub-layer 3131 may have the magnetic anisotropy and the second hard axis. The coil 33 may be the helical structure and have the axial direction. The angle γ between the second hard axis and the axial direction may be in the range of 0° ≤ γ ≤ 20° . When the angle γ between the second hard axis and the axial direction is between 0° and 20° , an increased number of magnetic flux lines may align along the second hard axis of the magnetic film sub-layer 3131. In this way, the magnetic permeability of the second magnetic layer 313 may be effectively reduced, and the loss in the inductor 30 may be lowered. When the angle γ between the second hard axis and the axial direction is 0°, the hysteresis loss and the eddy current loss of the inductor 30 may be further reduced, and the efficiency of the inductor 30 may be improved.

Other aspects of the magnetic core 31, the second magnetic layer 313, the magnetic film sub-layers 3131, the first hard axis, and the second hard axis may be referred to the description of the above embodiments, which will not be repeated herein.

As shown in FIGS. 10 and 11, in some embodiments, the coil 33 may include the plurality of first wires 331 and the plurality of second wires 333. The plurality of first wires 331 may be spaced apart from each other along the extension direction of the circuit board 10 and may be disposed at a same side of the magnetic core 31. The plurality of second wires 333 may be spaced apart from each other along the extension direction of the circuit board 10 and may be disposed at another side of the magnetic core 31 opposite the plurality of first wires 331. The plurality of first wires 331 and the plurality of second wires 333 may be alternately and sequentially connected in series to each other. It may be understood that the plurality of first wires 331 may be arranged on a same layer. The plurality of first wires 331 may be obtained from a same conductive layer by performing processes such as exposure, development, and etching. The plurality of second wires 333 may be arranged on a same layer; the plurality of second wires 333 may be obtained from a same conductive layer by performing processes such as exposure, development, and etching. For the configuration in which the coil 33 extends along the thickness direction of the circuit board 10, when the coil 33 having a plurality of turns needs to be prepared, the number of needed conductive layers may be the number of turns adding one. That is, when the coil 33 has n turns, n+1 conductive layers may be needed. Therefore, when the coil 33 having the plurality of turns needs to be prepared, the plurality of conductive layers on the circuit board 10 may need to be etched, and the plurality of turns may be obtained by performing a plurality of via-hole processes. In contrast, in the present embodiment, only two conductive layers may be needed to achieve any desired number of turns in the coil 33. In this way, a preparation process for the coil 33 may be simplified. Even when the number of the plurality of turns is large, the thickness of the circuit board 10 may not be increased, such that the circuit board 10 may be made thinner. The number of the plurality of turns of the coil 33 may not be limited by the thickness of the circuit board 10, greater design flexibility may be provided for any number of the plurality of turns of the coil 33.

Descriptions of other aspects of the coil 33 may be referred to the description of the above embodiments, which will not be repeated herein.

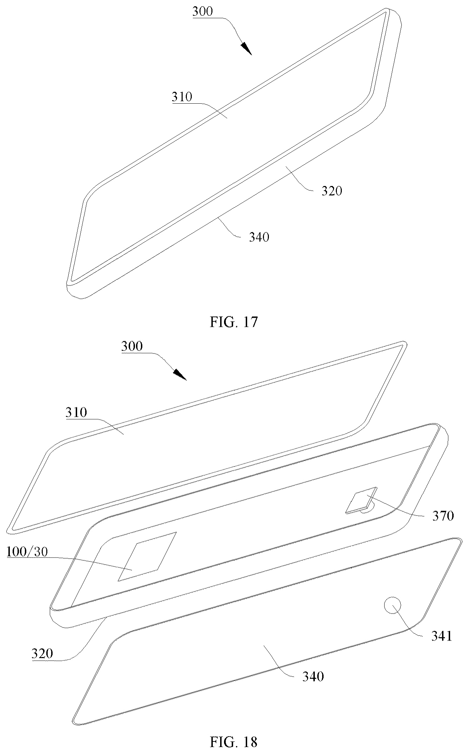

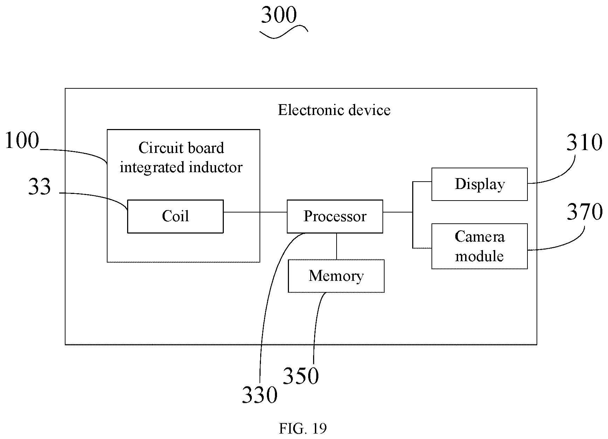

As shown in FIGS. 17 to 19, the present disclosure further provides an electronic device 300 including a display 310, the circuit board integrated inductor 100 or the inductor 30 according to the present disclosure, and a processor 330. The processor 330 may be electrically connected to the coil 33 in the circuit board integrated inductor 100 or the inductor 30 and to the display 310. The processor 330 may be configured to control magnitude and a direction of a current flowing through the coil 33 and control displaying of the display 310.

The electronic device 300 of the present disclosure may be, but not limited to, a portable electronic device, such as a mobile phone, a tablet computer, a laptop computer, a desktop computer, a smart bracelet, a smart watch, an e-reader, or a game console. In the embodiments of the present disclosure, the electronic device 300 is illustrated based on the mobile phone as an example, and the example shall not be interpreted as limiting the scope of the present disclosure.

Detailed descriptions of the circuit board integrated inductor 100 and the inductor 30 may be referred to the description of the above embodiments, which will not be repeated herein.

In some embodiments, the display 310 may be, but not limited to, one or more of the following: a liquid crystal display (LCD), a light-emitting diode display (LED), a micro light-emitting diode display (Micro LED), a sub-millimeter light-emitting diode display (Mini LED), or an organic light-emitting diode display (OLED).

In some embodiments, the processor 330 may include one or more general-purpose processors. The general-purpose processor may be any type of device capable of processing electronic instructions, including a central processing unit (CPU), a microprocessor, a microcontroller, a main processor, a controller, an ASIC, and so on. The processor may execute various types of digitally stored instructions, such as software or firmware programs stored in a memory, so as to enable a computing device to provide a wide range of services.

In some embodiments, the electronic device 300 may further include a memory 350. The memory 350 may be configured to store program codes required for the processor 330 to operate, program codes required for controlling the display 310, and displayed content of the display 310, and the like. In some embodiments, the memory 350 may include a volatile memory, such as a random access memory (RAM). The memory 350 may further include a non-volatile memory (NVM), such as a read-only memory (ROM), a flash memory (FM), a hard disk drive (HDD), or a solid-state drive (SSD). The memory 350 may further include combination of the above types of memories.

In some embodiments, the electronic device 300 of the present disclosure may further include a housing 340, a middle frame 320, and a camera module 370. The housing 340 may be disposed opposite to the display 310, the middle frame 320 may be disposed between the display 310 and the housing 340. A side of the middle frame 320 may be exposed from the housing 340 and the display 310. The middle frame 320 and the housing 340 may enclose a receiving space (not shown in the drawing), so as to receive the processor 330, the memory 350, and the camera module 370. The camera module 370 may be electrically connected to the processor 330 and may be configured to capture, when being controlled by the processor 330, images.

In some embodiments, the housing 340 may have a light-transmitting portion 341, and the camera module 370 may capture the images through the light-transmitting portion 341 on the housing 340.

That is, the camera module 370 in the present embodiment may be a rear camera module 370. It should be understood that, in other embodiments, the light-transmitting portion 341 may be formed on the display 310, and that is, the camera module 370 may be a front camera module 370. In the schematic diagram of the present embodiment, the light-transmitting portion 341 may be illustrated as an opening. In other embodiments, the light-transmitting portion 341 may not be an opening, but may be a light-transmitting material, such as plastic, glass, and so on.

It may be understood that the electronic device 300 in the present embodiment is merely represented in one form, in which the circuit board integrated inductor 100 or the inductor 30 is configured. It shall not be interpreted as limiting the electronic device 300 provided by the present disclosure, and it shall not be interpreted as limiting the circuit board integrated inductor 100 or the inductor 30 provided by the various embodiments of the present disclosure.

Terms "embodiment" and "implementation" used herein may imply that specific features, structures, or characteristics described in an embodiment may be included in at least one embodiment of the present disclosure. The terms at various sections in the specification does not necessarily refer to one embodiment, nor mutually exclusive, independent, or alternative embodiments. Any ordinary skilled person in the art shall explicitly and implicitly understand that the embodiments described herein may be combined with other embodiments. Furthermore, it shall be understood that the features, structures, or characteristics described in the various embodiments of the present disclosure may be arbitrarily combined, as long as the combination does not cause conflict, to form any other embodiment that remains within the spirit and scope of the present disclosure.

Finally, it should be noted that the above embodiments are provided to illustrate the technical solutions of the present disclosure and not to limit the present disclosure. Although the present disclosure is described in detail by referring to the above embodiments, any ordinary skilled person in the art shall understand that modifications or equivalent replacements to the technical solutions of the present disclosure shall not depart from the spirit and the scope of the present disclosure.

## Claims

1. A circuit board integrated inductor, comprising:
a circuit board; and
an inductor, comprising a magnetic core and a coil, wherein the magnetic core is embedded in the circuit board, and the coil is at least partially embedded in the circuit board and surrounds an outer periphery of the magnetic core;
wherein, the magnetic core comprises a first magnetic layer and a second magnetic layer insulated from the first magnetic layer; the first magnetic layer comprises a plurality of magnetic sub-members, each of the plurality of magnetic sub-members extends along a first direction, and the plurality of magnetic sub-members are spaced apart from each other along a second direction and arranged on a surface of the second magnetic layer, wherein the first direction intersects the second direction.

2. The circuit board integrated inductor according to claim 1, wherein, the coil is a helical structure and winds around an axial direction; each of the plurality of magnetic sub-members has magnetic anisotropy and a first hard axis, an angle α between the first hard axis and the axial direction is in a range of 0° ≤ α ≤ 20°.

3. The circuit board integrated inductor according to claim 1, wherein, each of the plurality of magnetic sub-members has magnetic anisotropy and a first hard axis, an angle β between the first hard axis and the first direction is in a range of 0° ≤ β ≤ 20°.

4. The circuit board integrated inductor according to claim 1, wherein, along the second direction, a width w of each of the plurality of magnetic sub-members is in a range of 100 µm ≤ w ≤ 500 µm, and a spacing d between adjacent two of the plurality of magnetic sub-members is in a range of 10 µm ≤ d ≤ 50 µm.

5. The circuit board integrated inductor according to claim 1, wherein a total area of orthographic projections of all of the plurality of magnetic sub-members onto a surface of the second magnetic layer facing the first magnetic layer is s1, and an area of the surface of the second magnetic layer facing the first magnetic layer is s2, and 50% ≤ s1/s2 ≤ 98%.

6. The circuit board integrated inductor according to any one of claims 1 to 5, wherein, the second magnetic layer comprises N magnetic film sub-layers and at least N-1 insulating sub-layers, the N magnetic film sub-layers and the at least N-1 insulating sub-layers are alternately stacked sequentially along a thickness direction of the circuit board, and the N ≥ 2 and is a positive integer.

7. The circuit board integrated inductor according to claim 6, wherein, each of the N magnetic film sub-layer has magnetic anisotropy and a second hard axis, the coil is a helical structure, winding around the axial direction, and an angle γ between the second hard axis and the axial direction is in a range 0° ≤ γ ≤ 20°.

8. The circuit board integrated inductor according to claim 7, wherein, each of the plurality of magnetic sub-members has magnetic anisotropy and a first hard axis, an angle θ between the first hard axis and the second hard axis is in a range of 0° ≤ θ ≤ 20°.

9. The circuit board integrated inductor according to any one of claims 1-5, 7, or 8, wherein, the coil comprises a plurality of first wires and a plurality of second wires; the plurality of first wires are spaced apart from each other along an extension direction of the circuit board and disposed at a same side of the magnetic core; the plurality of second wires are spaced apart from each other along the extension direction of the circuit board and disposed at another side of the magnetic core opposite to the plurality of first wires; and the plurality of first wires and the plurality of second wires are connected in-series to each other alternately.

10. The circuit board integrated inductor according to claim 9, wherein, the circuit board comprises a first conductive layer and a second conductive layer stacked on and spaced apart from the first conductive layer, the plurality of first wires are formed on the first conductive layer; and the plurality of second wires are formed on the second conductive layer.

11. The circuit board integrated inductor according to claim 10, wherein, the circuit board has: a first surface; a second surface facing away from the first surface along the thickness direction of the circuit board; and a plurality of via holes penetrating the circuit board along the thickness direction of the circuit board;
the plurality of first wires are spaced apart from each other and arranged on the first surface of the circuit board, and the plurality of second wires are spaced apart from each other and arranged on the second surface of the circuit board;
the coil further comprises a plurality of electrical connection members, each of the plurality of electrical connection members is disposed in a respective one of the via holes and electrically connects a respective one of the plurality of first wires with a respective one of the plurality of second wires, so as to enable the plurality of first wires and the plurality of second wires to be connected in series to each other alternately.

12. The circuit board integrated inductor according to claim 9, wherein, an angle δ1 between an extension direction of each of the plurality of first wires and an extension direction of each of the plurality of magnetic sub-members is in a range of 80° ≤ δ1 ≤ 100°; the angle δ2 between an extension direction of each of the plurality of second wires and the extension direction of each of the plurality of magnetic sub-members is in a range of 80° ≤ δ2 ≤ 100°.

13. An inductor, comprising:
a magnetic core, comprising a first magnetic layer and a second magnetic layer insulated from the first magnetic layer; wherein the first magnetic layer comprises a plurality of magnetic sub-members, each of the plurality of magnetic sub-members extends along a first direction; the plurality of magnetic sub-members are spaced apart from each other along a second direction and arranged on a surface of the second magnetic layer; the first direction intersects the second direction; and
a coil, winding around an outer periphery of the magnetic core.

14. The inductor according to claim 13, wherein, each of the plurality of magnetic sub-members has magnetic anisotropy and a first hard axis, the coil is a helical structure, winding around an axial direction, and an angle α between the first hard axis and the axial direction is in a range of 0° ≤ α ≤ 20°.

15. The inductor according to claim 13, wherein, each of the plurality of magnetic sub-members has magnetic anisotropy and a first hard axis; an angle β between the first hard axis and the first direction is in a range of 0° ≤ β ≤ 20°.

16. The inductor according to claim 13, wherein, along the second direction, a width w of each of the plurality of magnetic sub-members is in a range of 100 µm ≤ w ≤ 500 µm, and a spacing d between adjacent two of the plurality of magnetic sub-members is in a range of 10 µm ≤ d ≤ 50 µm.

17. The inductor according to claim 13, wherein, a total area of orthographic projections of all of the plurality of magnetic sub-members onto a surface of the second magnetic layer facing the first magnetic layer is s1, and an area of the surface of the second magnetic layer facing the first magnetic layer is s2, and 50% ≤ s1/s2 ≤ 98%.

18. The inductor according to any one of claims 13 to 17, wherein, the second magnetic layer comprises N magnetic film sub-layers and at least N-1 insulating sub-layers, the N magnetic film sub-layers and the at least N-1 insulating sub-layers are alternately stacked sequentially along a thickness direction of the circuit board, and the N ≥ 2 and is a positive integer; and
each of the N magnetic film sub-layer has magnetic anisotropy and a second hard axis, the coil is a helical structure, winding around the axial direction, and an angle γ between the second hard axis and the axial direction is in a range 0° ≤ γ ≤ 20°.

19. The inductor according to claim 18, wherein, each of the plurality of magnetic sub-members has magnetic anisotropy and a first hard axis, an angle θ between the first hard axis and the second hard axis is in a range of 0° ≤ θ ≤ 20°.

20. An electronic device, comprising:
a display ;
the circuit board integrated inductor according to any one of claims 1 to 12 or the inductor according to any one of claims 13 to 19; and
a processor, electrically connected to the coil in the circuit board integrated inductor or in the inductor and to the display, wherein, the processor is configured to control a magnitude and a direction of a current flowing through the coil..
